# EUROPEAN PATENT SPECIFICATION

(11) **EP 2 756 951 B1**
(45) Date of publication and mention of the grant of the patent: **22.11.2017**
(21) Application number: 12822691.7
(22) Date of filing: 31.05.2012
(51) Int. Cl.: B32B 37/06, B32B 37/10, B32B 38/00, H01L 41/45, H01L 41/257

(54) **CONTINUOUS PRODUCTION PROCESS FOR POLYTETRAFLUOROETHYLENE FUNCTIONAL FILM FOR ELECTRO-MECHANICAL ENERGY CONVERSION**
VERFAHREN ZUR KONTINUIERLICHEN HERSTELLUNG EINES POLYTETRAFLUORETHYLEN-FUNKTIONSFILMS FÜR ELEKTROMECHANISCHE ENERGIEUMWANDLUNG
PROCÉDÉ DE PRODUCTION EN CONTINU DE FILM FONCTIONNEL DE POLYTÉTRAFLUOROÉTHYLÈNE POUR LA CONVERSION D'ÉNERGIE ÉLECTROMÉCANIQUE

(30) Priority: 10.08.2011 CN 201110227833
(43) Date of publication of application: 23.07.2014
(73) Proprietor: Shanghai Dagong New Materials Co., Ltd., Shanghai 201700 (CN)
(72) Inventor: GONG, Xiangshan, Shanghai 201700 (CN); ZHANG, Xiaoqing, Shanghai 200092 (CN); TSUGUNARI, Miya, Shanghai 201700 (CN)
(74) Representative: Lermer, Christoph
(86) International application number: PCT/CN2012/076329
(87) International publication number: WO 2013/020410

(56) References cited:
- EP-A1- 0 050 185
- EP-A1- 1 125 731
- WO-A2-2010/066347
- AT-B- 397 062
- CN-A- 1 933 206
- CN-A- 102 350 850
- DE-A1- 19 802 662
- US-A1- 2003 113 546
- XUEWEN WANG ET AL: "Mechanical and electrical properties of laminated polytetrafluoroethylene films", IEEE TRANSACTIONS ON DIELECTRICS AND ELECTRICAL INSULATION, IEEE SERVICE CENTER, PISCATAWAY, NJ, US, vol. 18, no. 1, February 2011 (2011-02), pages 57-63, XP011329530, ISSN: 1070-9878, DOI: 10.1109/TDEI.2011.5704493
- XIAOQING ZHANG ET AL: "Preparation and Piezoelectricity of Piezoelectrets Made of Polytetrafluoroethylene", FERROELECTRICS, vol. 408, no. 1, November 2010 (2010-11), pages 55-61, XP055181384, ISSN: 0015-0193, DOI: 10.1080/00150193.2010.485018
- XIAOQING ZHANG ET AL: "Quasi-static and dynamic piezoelectric responses of layered polytetrafluoroethylene ferroelectrets", JOURNAL OF PHYSICS D: APPLIED PHYSICS, INSTITUTE OF PHYSICS PUBLISHING LTD, GB, vol. 47, no. 1, 3 December 2013 (2013-12-03), page 15501, XP020255726, ISSN: 0022-3727, DOI: 10.1088/0022-3727/47/1/015501 [retrieved on 2013-12-03]
- QIU, XUN-LIN ET AL.: 'Piezoelectric Activity of PFA/Porous PTFE/PFA Sandwich - structure Compound Film' JOURNAL OF HARBIN UNIVERSITY OF SCIENCE AND TECHNOLOGY vol. 7, no. 6, December 2002, pages 111 - 112, XP008173025

## Description

### TECHNICAL FIELD

This invention relates to a method for preparing functional films based on polymers, and in particular a continuous production process for producing electromechanical energy conversion films made from polytetrafluoroethylene.

### BACKGROUND

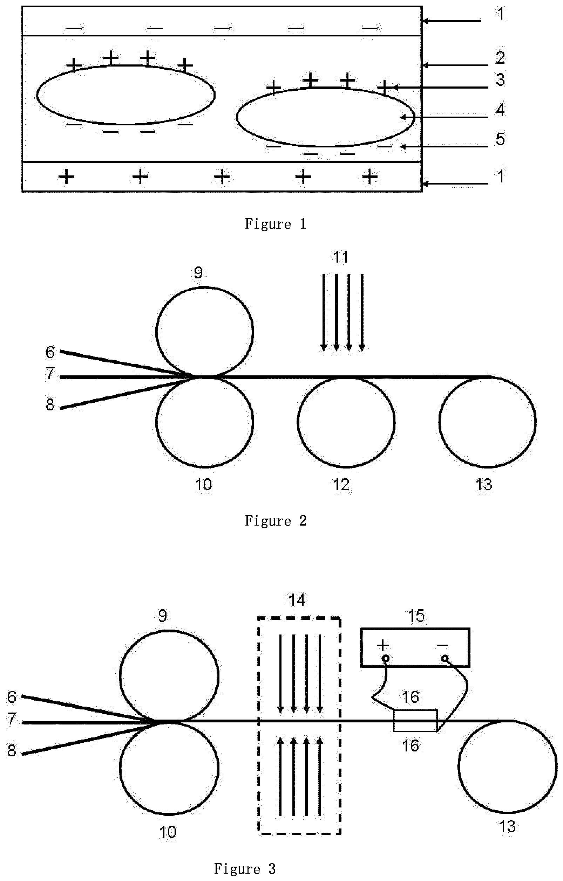

Piezoelectrets, also known as ferroelectrets, are space-charge electrets with piezoelectric effect (i.e., electromechanical energy conversion effect). Such piezoelectric effect in piezoelectrets is associated with the capability of the materials storing real charges in a long term and the special void structure of the materials. The schematic view shown in Figure 1 indicates the microstructure and the space charge distribution in a piezoelectret material, and the mechanism of piezoelectric effect.

Piezoelectrets are a new class of electromechanical energy conversion materials developed around 1990. Such materials exhibit strong piezoelectric effect comparable to piezoelectric ceramics as well as very good flexibility like polymer ferroelectric materials, such as polyvinylidene fluoride (PVDF) and its copolymers. Such unique features make piezoelectrets very promising in applications of various types of electro-acoustic transducers, pressure sensors, ultrasonic transducers, micro vibration energy harvesters, medical care and so on.

So far the only commercially available piezoelectret is polypropylene (PP) piezoelectret films produced by EmFit Company in Finland. And most of the applications of piezoelectrets are based on PP piezoelectret films presently. However, due to the relatively poor charge storage stability in PP material the working temperature of PP piezoelectrets is less than 60 °C. The piezoelectric effect in PP piezoelectrets will decay sharply or even completely disappear if the environment temperature is above this working temperature. For this reason, the development of thermally stable piezoelectrets has been pursued in several laboratories and much progress has been made. But there is no report on thermally stable piezoelectrets in large scale produced by using a continuous production line.

The publication "Mechanical and electric properties of laminated polytetrafluoroethylene films" by Xuewen Wang et al., IEEE Transactions on Dielectrics and Electrical Insulation, IEEE Service Center, Piscataway, NJ, US, vol 18, no. 1, February 2011, pages 57-63 discloses laminated polytetrafluoroethylene (PTFE) films, which are made of compact and porous PTFE layers, that are prepared through the process of sintering.

The publication "Preparation and Piezoelectricity of Piezoelectrets Made of Polytetrafluoroethylene" by Xiaoqing Zhang et al., vol 408, no. 1, November 2010, pages 55-61 discloses polytetrafluoroethylene (PTFE) films with void structure being prepared by a fusion bonding process. Such void films are piezoelectric after proper corona charging.

### SUMMARY OF THE INVENTION

Provided herein is a method used for a continuous production process of polytetrafluoroethylene (PTFE) electro-mechanical energy conversion functional films. This process is applicable to mass and continuous production. The products exhibit better thermal stability and piezoelectricity than PP piezoelectret films.

Also provided herein is the PTFE electro-mechanical energy conversion functional film produced by the method mentioned above.

The technical solution provided in this invention is as follows: Acontinuous production process, for polytetrafluoroethene(PTFE) functional films, for fabricating electro-mechanical energy conversion,contains two steps of the thermal bonding of the stacks of the layers with micro-pore structure and the electrical polarization of such thermally bonded laminated films. The features of such process are as the followings: the step of the thermal bonding of the stacks of the layers with micro-pore structure is that there should be at least two compact PTFE layers and one porous PTFE layer sandwiched between two adjacent compact PTFE films. And then the stacks of the compact and porous PTFE films are fed into the pair of the upper and lower hot press rollers and be thermally bonded there forming the laminated film; The laminated film is finally electrically polarized resulting in PTFE piezoelectret film.
The compact PTFE films mentioned above mean the PTFE films with compact structure produced by various processes, such as turning films, cast films, blow-molded films and so on. The porous PTFE films mentioned above means the PTFE films with porous structure produced by various processes.

On base of the project above, the electrical polarization of the laminated films is as follow: the laminated film is corona charged by putting the laminated film in the area between the electrode roller and the corona electrode. The corona charged laminated PTFE film is thus obtained and collected by wind up rollers.

On base of the project above, the electrical polarization of the laminated films is as follow: the electrodes are coated on both side of the laminated film in the electrode-coating area. And then the laminated film with electrodes is fed into the contact-charging area to be polarized by using contact charging. The charged laminated PTFE film is thus obtained and collected by wind up rollers.

On base of the project above, the laminated PTFE film, exported from the upper and lower hot press rollers, passes through the corona-charging area where it is close to the surface of the electrode roller. And then it is collected by the wind up roller to complete the production of PTFE piezoelectret film.

On base of the project above, two compact PTFE layers with a thickness of 2∼40µm and one porous PTFE layer with a thickness of 2∼400µm are used. The porous PTFE layer is sandwiched between the two compact PTFE layers, forming layer stacks. The layer stacks are then thermally bonded and form a laminated film by a pair of the upper and lower heat press rollers. The surfaces of the upper and lower heat press rollers are with cross patterns. The diameters of the upper and lower heat press rollers are of 150 mm. The temperatures of the upper and lower heat press rollers are in the range of 100 to 450 °C. The pressures, applied to the film stacks by the upper and lower heat press rollers, are in the range of 0.1 to 200 MPa. The speed of the film stacks going through the upper and lower heat press rollers is in the range of 0.1 to 20 m/min. The laminated PTFE films are fabricated after the treatment of the thermal bonding. The laminated PTFE films are then electrically polarized in the corona-charging area. The voltage of the corona charging is in the range of 1 to 200 kV. The distance between the corona electrode and the electrode roller is in the range of 0.1 to 50 cm. The temperature in the corona area is in the range of -40 to 380 °C. PTFE piezoelectret films are fabricated after the treatment of corona charging.

On base of the project above, an electrode coating system and a contact charging system are set between the upper, lower hot press rollers and the wind up roller. The laminated PTFE film exported from the upper and lower hot press rollers first enters the electrode coating system, forming good electrodes on both side of the films, and then goes into the contact charging system under the driving of the wind up roller. A high DC voltage is applied to the upper and lower electrodes of the laminated PTFE film to complete polarization. Finally, the polarized laminated PTFE film is collected by wind up rollers and the fabrication of PTFE piezoelectret film is ready.

On base of the project above, two compact PTFE layers with a thickness of 20∼200µm and one porous PTFE layer with a thickness of 20∼1000µm are used. The porous PTFE layer is sandwiched between the two compact PTFE layers, forming layer stacks. The layer stacks are then thermally bonded and form a laminated film by a pair of the upper and lower heat press rollers. The surfaces of the upper and lower heat press rollers are with cross patterns. The diameters of the upper and lower heat press rollers are of 150 mm. The temperatures of the upper and lower heat press rollers are in the range of 150 to 550 °C. The pressures, applied to the film stacks by the upper and lower heat press rollers, are in the range of 2 to 400 MPa. The speed of the film stacks going through the upper and lower heat press rollers is in the range of 0.5 to 60 m/min. The laminated PTFE films are fabricated after the treatment of the thermally bonding. The fabricated laminated PTFE film then enters the electrode coating system and aluminum electrodes, with a thickness of 2∼1000 nm, are coated on both sides of the laminated PTFE film. After that, a DC voltage in the range of 100∼20000V is applied to the upper and lower electrodes on the surfaces of the laminated PTFE film. The temperature of the contact charging system is set to be -40∼380°C. The PTFE piezoelectet film is fabricated after contact charging.

The PTFE electromechanical energy conversion functional films, produced by the continuous production process, consist of at least two compact PTFE layers, and the layer stacks are formed by using at least one porous PTFE layer sandwiched between every two adjacent compact PTFE layers

Specifically, the electromechanical function films are laminated films consisting porous PTFE layers and compact PTFE layers in a sequential cascade arrangement. The number of layers of porous PTFE is n, n≥1. The number of layers of compact PTFE is n+1. For example, a PTFE piezoelectret film consisting of one porous PTFE layer sandwiched in two compact PTFE layers. Another example is a PTFE piezoelectret film consisting of two porous PTFE layers sandwiched in three compact PTFE layers.

The advantages of this invention lie in that the production process is continuous and high production efficiency. The electromechanical energy conversion functional films, based on PTFE, exhibit an excellent piezoelectric effect and improved thermal stability.

### BRIEF DESCRIPTION OF THE DRAWINGS

Figure 1 is the schematic views of the micro structure, space charge distribution, and piezoelectric mechanism of piezoelectrets.
Figure 2 is the schematic of the process for fabricating PTFE piezoelectret films by using corona charging.
Figure 3 is the schematic of the process for fabricating PTFE piezoelectret films by using contact charging.
Figure 4 is the piezoelectric *d*₃₃ coefficient as a function of applied pressure in the Example 1.
Figure 5 is the isothermal decay of piezoelectric *d*₃₃ coefficient at 120°C of the PTFE piezoelectret film in the Example 1.
Figure 6 is the isothermal decay of piezoelectric *d*₃₃ coefficient at 200°C of the PTFE piezoelectret film in the Example 1.
Figure 7 is the schematic of the structure for a PTFE piezoelectret film.

**Label instructions**

| | | |
|---|---|---|
| 1-electrode | 2-electret matrix | 3- positive space charge |
| 4-air bubble | 5-negative space charge | 6-compact PTFE layer |
| 7-porous PTFE layer | 8-compact PTFE layer | 9-upper heat press roller |
| 10-lower heat press roller | 11-corona electrode | 12-electrode roller |
| 13-wind up roller | 14-electro coating system | |
| 15, 16-contact charging system (15: high voltage DC power supplier. 16: electrode) | | |

### DETAILS OF SPECIFIC IMPLEMENTATION

### Example 1

Fig.1 shows the microstructure and charge distribution of a piezoelectret involved in the present invent, and the schematic view of the piezoelectric effect in such material. A continuous production process for fabricating the electromechanical energy conversion functional films based on PTFE consists of two steps of a thermally bonding of layer stacks with void structure and an electrical polarization.

The steps for the thermal bonding of the laminated films with void structure are as followings. A porous PTFE layer with a thickness of 5 µm (7) is sandwiched by two 5µm thick compact PTFE layers (6 and 8). And then the stacks of layers are fed into a pair of heat press rollers (9, 10) and thermally bonded by them. The diameters of the heat press rollers are 150 mm. The surfaces of the heat press rollers are with cross patterns. The temperatures of the heat press rollers are set at 150 °C. The pressure of the rollers applying on the film system is 1 MPa. The speed of the film system between the two rollers is 0.5 m/min. After the hot pressing, a laminated PTFE film with micro porous structure is obtained.

Fig. 2 shows the schematics of the process for fabricating PTFE piezoelectret films by using corona charging. The corona charging for a laminated PTFE film is performed by feeding the laminated PTFE film into the corona charging area formed by electrode rollers 11 and 12. The corona voltage is 20 kV. The distance between the electrode roller (12) and corona electrode (11) is 4 cm. The temperature in the corona area is 25°C. After the treatment of corona charging, PTFE piezoelectret film is obtained. The PTFE piezoelectret film is finally collected by a wind up roller 13.

The test results of the PTEF piezoelectret film with microporous structure mentioned above are as followings.

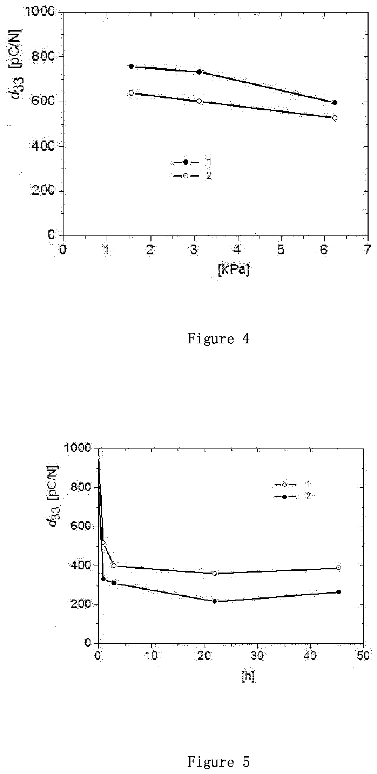

Fig.4 shows the quasi-static *d*₃₃ coefficient of a PTEF piezoelectret sample as a function of applied pressure. This figure indicates that the quasi-static *d*₃₃ coefficients up to 800 pC/N are achieved, which is much larger than the *d*₃₃ values of commercial PP piezoelectret films (OS01:25 pC/N; HS01:230 pC/N). This figure also indicates that the piezoelectric *d*₃₃ in the PTFE piezoelectret sample has relatively good linearity in the applied pressure of 1 to 6 kPa.

Results on the isothermal decay of the quasi-static *d*₃₃ coefficients in PTFE piezoelectret samples at an annealing temperature of 120 °C are shown in Fig.5. The values of *d*₃₃ decrease in the initial stage of annealing (within 3 hours). After 3 hours annealing, *d*₃₃ coefficients remain in the level of 200 to 400 pC/N. These results indicate that the thermal stability of piezoelectric effect in PTFE piezoelectret films is much better than that in commercial PP piezoelectret films. The working temperature of PP piezoelectret films is less than 60 °C. And a strong deformation can happen and the piezoelectric effect disappears when the PP piezoelectret films are annealed at 120°C.).

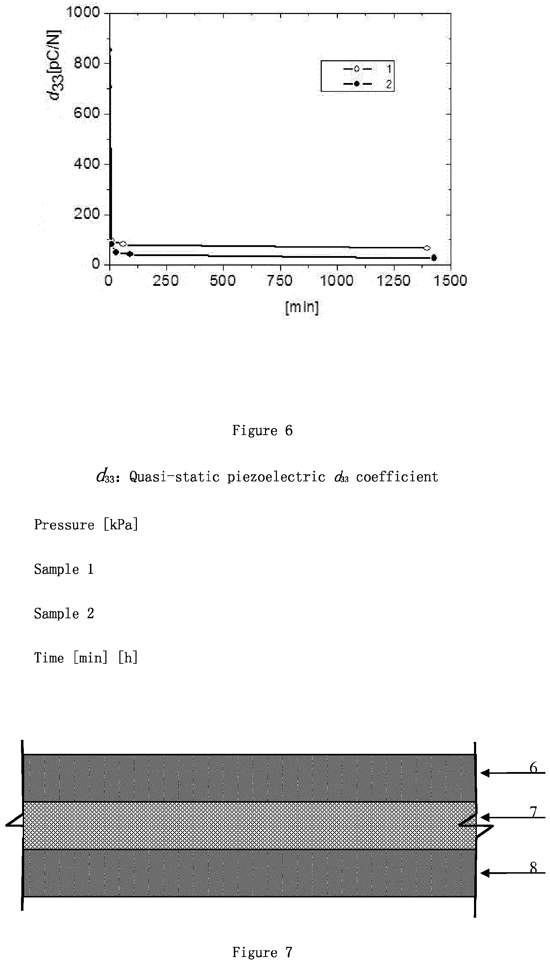

Results on the isothermal decay of the quasi-static *d*₃₃ coefficients in PTFE piezoelectret samples at an annealing temperature of 200 °C are shown in Fig.6. By the pre-aging treatment of the PTFE piezoelectret films, fabricated by using the process described in Example 1, thermally stable piezoelectret films, with a work temperature of 200 °C, can be obtained.

### Example 2

Set an electrode coating system (14) and a contact charging system (15,16) between a pair of heat press rollers (9,10) and the wind up roller (13).

A continuous production process for fabricating the electromechanical energy conversion functional films based on PTFE consists of two steps of a thermal bonding of layer stacks with void structure and an electrical polarization.

The steps for the thermal bonding of the laminated films with void structure are as followings. A porous PTFE layer with a thickness of 400 µm is sandwiched by two 20µm thick compact PTFE layers. And then the stacks of layers are fed into a pair of heat press rollers (9, 10) and thermally bonded by them. The diameters of the heat press rollers are 150 mm. The surfaces of the heat press rollers are with cross patterns. The temperatures of the heat press rollers are set at 420 °C. The pressure of the rollers applying on the film system is 200 MPa. The speed of the film system between the two rollers is 32 m/min. After the hot pressing, a laminated PTFE film with micro porous structure is obtained.

Fig. 3 shows the schematics of the process for fabricating PTFE piezoelectret films by using contact charging. The contact charging for a laminated PTFE film is performed by feeding the laminated PTFE film into the electrode coating system 14 (electrode coating area). Both sides of the films are metallized by aluminum electrodes evaporation 100 nm in thickness. After that, a DC voltage of 8000V is applied between the aluminum electrodes. The temperature in the contact charging area (15,16) is 25°C. After the treatment of contact charging, PTFE piezoelectret film is obtained. The PTFE piezoelectret film is finally collected by a wind up roller 13.

The products, fabricated by using the present invention, consist of porous PTFE layers and compact PTFE layers in a sequential cascade arrangement. The number of layers of porous PTFE is n, n≥1. The number of layers of compact PTFE is n+1. For example, a PTFE piezoelectret film consisting of one porous PTFE layer sandwiched in two compact PTFE layers. Another example is a PTFE piezoelectret film consisting of two porous PTFE layers sandwiched in three compact PTFE layers.

The quasi-static piezoelectric *d*₃₃ coefficient in film, fabricated in the Example 2, is 1362 pC/N at an applied pressure of 3.2kPa, indicating that even more strong piezoelectric effect can be achieved by an optimization of electric polarization parameters.

### Example 3

A porous PTFE layer with a thickness of 2 µm (7) is sandwiched by two 50 µm thick compact PTFE layers (6 and 8). And then the stacks of layers are fed into a pair of heat press rollers (9, 10) and thermally bonded by them. The diameters of the heat press rollers are 150 mm. The surfaces of the heat press rollers are with cross patterns. The temperatures of the heat press rollers are set at 150 °C. The pressure of the rollers applying on the film system is 200 MPa. The speed of the film system between the two rollers is 10 m/min. After the hot pressing, a laminated PTFE film with micro porous structure is obtained.

Fig. 2 shows the schematics of the process for fabricating PTFE piezoelectret films by using corona charging. The corona charging for a laminated PTFE film is performed by feeding the laminated PTFE film into the corona charging area formed by electrode rollers 11 and 12. The corona voltage is 20 kV. The distance between the electrode roller (12) and corona electrode (11) is 4 cm. The temperature in the corona area is 25°C. After the treatment of corona charging, PTFE piezoelectret film is obtained. The PTFE piezoelectret film is finally collected by a wind up roller 13.

The quasi-static piezoelectric *d*₃₃ coefficient in film, fabricated in the Example 3, is 998 pC/N at an applied pressure of 3.2kPa.

### Example 4

A porous PTFE layer with a thickness of 1000 µm (7) is sandwiched by two 200 µm thick compact PTFE layers (6 and 8). And then the stacks of layers are fed into a pair of heat press rollers (9, 10) and thermally bonded by them. The diameters of the heat press rollers are 150 mm. The surfaces of the heat press rollers are with cross patterns. The temperatures of the heat press rollers are set at 550 °C. The pressure of the rollers applying on the film system is 400 MPa. The speed of the film system between the two rollers is 60 m/min. After the hot pressing, a laminated PTFE film with micro porous structure is obtained.

Fig. 2 shows the schematics of the process for fabricating PTFE piezoelectret films by using corona charging. The corona charging for a laminated PTFE film is performed by feeding the laminated PTFE film into the corona charging area formed by electrode rollers 11 and 12. The corona voltage is 20 kV. The distance between the electrode roller (12) and corona electrode (11) is 4 cm. The temperature in the corona area is 25°C. After the treatment of corona charging, PTFE piezoelectret film is obtained. The PTFE piezoelectret film is finally collected by a wind up roller 13.

The quasi-static piezoelectric *d*₃₃ coefficient in film, fabricated in the Example 4, is 1928 pC/N at an applied pressure of 3.2kPa.

### Example 5

A porous PTFE layer with a thickness of 500 µm (7) is sandwiched by two 40µm thick compact PTFE layers(6 and 8). And then the stacks of layers are fed into a pair of heat press rollers (9, 10) and thermally bonded by them. The diameters of the heat press rollers are 150 mm. The surfaces of the heat press rollers are with cross patterns. The temperatures of the heat press rollers are set at 450 °C. The pressure of the rollers applying on the film system is 200MPa. The speed of the film system between the two rollers is 0.5 m/min. After the hot pressing, a laminated PTFE film with micro porous structure is obtained.

Fig. 2 shows the schematics of the process for fabricating PTFE piezoelectret films by using corona charging. The corona charging for a laminated PTFE film is performed by feeding the laminated PTFE film into the corona charging area formed by electrode rollers 11 and 12. The corona voltage is 20 kV. The distance between the electrode roller (12) and corona electrode (11) is 4 cm. The temperature in the corona area is 25°C. After the treatment of corona charging, PTFE piezoelectret film is obtained. The PTFE piezoelectret film is finally collected by a wind up roller 13.

The quasi-static piezoelectric *d*₃₃ coefficient in film, fabricated in the Example 5, is 2446 pC/N at an applied pressure of 3.2kPa.

## Claims

1. A continuous production process, for polytetrafluoroethene(PTFE) functional films, for fabricating electro-mechanical energy conversion,contains two steps of the thermal bonding of the stacks of the layers with micro-pore structure and the electrical polarization of such thermally bonded laminated films. The features of such process are as the followings: the step of the thermal bonding of the stacks of the layers with micro-pore structure is that there should be at least two compact PTFE layers (6, 8) and one porous PTFE layer (7) sandwiched between two adjacent compact PTFE films. And then the stacks of the compact and porous PTFE films are fed into the pair of the upper and lower hot press rollers (9, 10) and be thermally bonded there forming the laminated film; The laminated film is finally electrically polarized resulting in PTFE piezoelectret film.

2. According to claim 1, the features of the continuous production process of an electromechanical energy conversion functional film based on PTFE are as the followings. The charging step introduced in request 1 is that the laminated film is corona charged by putting the laminated film in the area between the electrode roller and the corona electrode. The corona charged laminated PTFE film is thus obtained and collected by wind up rollers.

3. According to claim 1, the features of the continuous production process of an electromechanical energy conversion PTFE functional film are as the followings. The charging step introduced in request 1 is that the electrodes are coated on both side of the laminated film in the electrode-coating area. And then the laminated film with electrodes is fed into the contact-charging area to be polarized by using contact charging. The corona charged laminated PTFE film is thus obtained and collected by wind up rollers.

4. According to claim 2, the features of the continuous production process of an electromechanical energy conversion PTFE functional film are as the followings. The laminated PTFE film, exported from the upper and lower hot press rollers (9, 10), passes through the corona-charging area where it is close to the surface of the electrode roller. And then it is collected by the wind up roller to complete the production of PTFE piezoelectret film.

5. According to claim 4, the features of the continuous production process of an electromechanical energy conversion PTFE functional film are as the followings. Two compact PTFE layers with a thickness of 2∼40µm and one porous PTFE layer with a thickness of 2∼400µm are used. The porous PTFE layer is sandwiched between the two compact PTFE layers, forming layer stacks. The layer stacks are then thermally bonded and form a laminated film by a pair of the upper and lower heat press rollers (9, 10). The surfaces of the upper and lower heat press rollers are with cross patterns. The diameters of the upper and lower heat press rollers are of 150 mm. The temperatures of the upper and lower heat press rollers are in the range of 100 to 450 °C. The pressures, applied to the film stacks by the upper and lower heat press rollers, are in the range of 0.1 to 200 MPa. The speed of the film stacks going through the upper and lower heat press rollers is in the range of 0.1 to 20 m/min. The laminated PTFE films are fabricated after the treatment of the thermal bonding. The laminated PTFE films are then electrically polarized in the corona-charging area. The voltage of the corona charging is in the range of 1 to 200 kV. The distance between the corona electrode (11) and the electrode roller (12) is in the range of 0.1 to 50 cm. The temperature in the corona area is in the range of -40 to 380 °C. PTFE piezoelectret films are fabricated after the treatment of corona charging.

6. According to claimt 3, the features of the continuous production process of an electromechanical energy conversion PTFE functional film are as follows. An electrode coating system (14) and a contact charging system (15, 16) are set between the upper, lower hot press rollers (9, 10) and the wind up roller (13). The laminated PTFE film exported from the upper and lower hot press rollers (9,10) first enters the electrode coating system (14), forming good electrodes on both side of the films, and then goes into the contact charging system (15, 16) under the driving of the wind up roller (13). A high DC voltage is applied to the upper and lower electrodes of the laminated PTFE film to complete polarization. Finally, the polarized laminated PTFE film is collected by wind up rollers and the fabrication of PTFE piezoelectret film is ready.

7. According to claim 6, the features of the continuous production process of an electromechanical energy conversion PTFE functional film are as followings. Two compact PTFE layers with a thickness of 20∼200µm and one porous PTFE layer with a thickness of 20∼1000µm are used. The porous PTFE layer is sandwiched between the two compact PTFE layers, forming layer stacks. The layer stacks are then thermally bonded and form a laminated film by a pair of the upper and lower heat press rollers (9, 10). The surfaces of the upper and lower heat press rollers are with cross patterns. The diameters of the upper and lower heat press rollers are of 150 mm. The temperatures of the upper and lower heat press rollers are in the range of 150 to 550 °C. The pressures, applied to the film stacks by the upper and lower heat press rollers, are in the range of 2 to 400 MPa. The speed of the film stacks going through the upper and lower heat press rollers is in the range of 0.5 to 60 m/min. The laminated PTFE films are fabricated after the treatment of the thermally bonding. The fabricated laminated PTFE film then enters the electrode coating system (14) and aluminum electrodes, with a thickness of 100 nm, are coated on both sides of the laminated PTFE film. After that, a DC voltage in the range of 100∼20000V is applied to the upper and lower electrodes on the surfaces of the laminated PTFE film. The temperature of the contact charging system is set to be -40∼380°C. The PTFE piezoelectet film is fabricated after contact charging.

## Patentansprüche

1. Ein kontinuierlicher Herstellungsprozess für funktionale Polytetrafluorethen (PTFE) Filme zur Herstellung elektro-mechanischer Energieumwandlung, der zwei Schritte des thermischen Verbindens der Stapel von Schichten mit Mikroporenstruktur und die elektrische Polarisation von solchen thermisch verbundenen beschichteten Filmen umfasst. Die Merkmale eines solchen Prozesses sind folgende: der Schritt des thermischen Verbindens der Stapel der Schichten mit Mikroporenstruktur besteht darin, dass es wenigstens zwei kompakte PTFE-Schichten (6, 8) und eine poröse PTFE-Schicht (7) gibt, die zwischen den benachbarten kompakten PTFE-Filmen geschichtet ist. Anschließend werden die Stapel von kompakten und porösen PTFE-Filmen in das Paar von oberer und unterer Heißpresswalze (9, 10) eingebracht und dort thermisch verbunden, um den beschichteten Film zu bilden; der beschichtete Film wird schließlich elektrisch polarisiert, was zu einem PTFE piezoelektrischen Film führt.

2. Prozess nach Anspruch 1, wobei die Merkmale des kontinuierlicher Herstellungsprozesses eines funktionalen Films zur elektromechanischen Energieumwandlung basierend auf PTFE folgende sind: der Schritt des Ladens aus Anspruch 1 besteht darin, dass der beschichtete Film Corona-entladen wird durch Einbringen des beschichteten Films in den Bereich zwischen der Elektrodenwalze und der Corona-Elektrode. Der Corona-geladene beschichtete PTFE-Film wird so erhalten und durch Aufrollwalzen aufgenommen.

3. Prozess nach Anspruch 1, wobei die Merkmale des kontinuierlicher Herstellungsprozesses eines funktionalen PTFE- Films zur elektromechanischen Energieumwandlung folgende sind: der in Anspruch 1 eingeführte Schritt des Ladens besteht darin, dass die Elektroden an beiden Seiten des beschichteten Films im Elektroden-Beschichtungs-Bereich beschichtet werden. Anschließend wird der beschichtete Film mit Elektroden in den Kontakt-Ladungs-Bereich eingeführt, um durch Kontakt- Laden polarisiert zu werden. Der Corona-geladene beschichtete PTFE-Film wird so erhalten und durch auf Aufrollwalzen aufgenommen.

4. Prozess nach Anspruch 2, wobei die Merkmale des kontinuierlicher Herstellungsprozesses eines funktionalen PTFE- Films zur elektromechanischen Energieumwandlung folgende sind: der beschichtete PTFE- Film, der von der oberen und unteren Heißpresswalzen (9, 10) ausgegeben wurde, geht durch den Corona-Ladungs-Bereich hindurch, wo er nahe der Oberfläche der Elektrodenwalze angeordnet ist. Und dann wir er durch eine Aufrollwalze aufgenommen, um die Herstellung eines PTFE piezoelektrischen Films abzuschließen.

5. Prozess nach Anspruch 4, wobei die Merkmale des kontinuierlicher Herstellungsprozesses eines funktionalen PTFE- Films zur elektromechanischen Energieumwandlung folgende sind: zwei kompakte PTFE-Schichten mit einer Dicke von 2 - 40µm und eine poröse PTFE-Schicht mit einer Dicke von 2 - 400µm werden verwendet. Die poröse PTFE-Schicht ist zwischen den zwei kompakten PTFE -Schichten geschichtet, um Schichtstapel zu bilden. Die Schichtstapel werden anschließend durch ein Paar von oberer und unterer Heißpresswalze (9,10) thermisch verbunden und bilden einen beschichteten Film. Die Oberflächen der oberen und unteren Heißpresswalze weisen Kreuzmuster auf. Die Durchmesser der oberen und unteren Heißpresswalze sind 150mm. Die Temperaturen der oberen und unteren Heißpresswalze sind im Bereich von 100°C bis 450°C. Die Drücke, die durch die obere und untere Heißpresswalze auf die Filmstapel ausgeübt werden sind im Bereich 0.1 bis 200 MPa. Die Geschwindigkeit der Filmstapel, die durch die obere und untere Heißpresswalze laufen, ist im Bereich von 0.1 bis 20m/min. Die beschichteten PTFE-Filme sind nach der Behandlung des thermischen Verbindens hergestellt. Die beschichteten PTFE-Filme werden dann im Corona-Ladungs-Bereich elektrisch polarisiert. Die Spannung der Corona-Entladung ist im Bereich von 1 bis 200 kV. Der Abstand zwischen der Corona-Elektrode (11) und der Elektrodenwalze (12) ist im Bereich von 0.1 bis 50cm.Die Temperatur im Corona -Bereich ist im Bereich von -40°C bis 380°C. Der PTFE piezoelektrische Film ist nach der Behandlung der Corona-Entladung hergestellt.

6. Prozess nach Anspruch 3, wobei die Merkmale des kontinuierlicher Herstellungsprozesses eines funktionalen PTFE- Films zur elektromechanischen Energieumwandlung folgende sind: ein Elektrodenbeschichtungssystem (14) und ein Kontaktladungssystem (15, 16) sind zwischen die obere, untere Heißpresswalze (9, 10) und die Aufrollwalze (13) gebracht. Der von der oberen und unteren Heißpresswalze (9, 10) ausgegebene beschichtet PTFE-Film tritt erst in das Elektrodenbeschichtungssystem (14), um auf beiden Seite der Filme gute Elektroden zu bilden, und geht dann untere dem Antrieb der Aufrollwalze (13) in das Kontaktladungssystem (15, 16). Eine hohe Gleichstrom-Spannung wird an die oberen und unteren Elektroden des beschichteten PTFE-Films angelegt, um die Polarisation zu vervollständigen. Schließlich wird der polarisierte beschichtet PTFE-Film durch Aufrollwalzen aufgenommen und die Herstellung des PTFE piezoelektrischen Films ist fertig.

7. Prozess nach Anspruch 6, wobei die Merkmale des kontinuierlicher Herstellungsprozesses eines funktionalen PTFE- Films zur elektromechanischen Energieumwandlung folgende sind: zwei kompakte PTFE-Schichten mit einer Dicke von 20 - 200µm und eine poröse PTFE-Schicht mit einer Dicke von 20 - 1000µm werden verwendet. Die poröse PTFE-Schicht ist zwischen den kompakten PTFE-Schichten gestapelt, um Schichtstapel zu bilden. Die Schichtstapel werden dann durch ein Paar von oberen und unteren Heißpresswalzen (9, 10) thermisch verbunden und bilden einen beschichteten Film. Die Oberflächen der oberen und unteren Heißpresswalzen sind mit Kreuzmustern versehen. Die Durchmesser der oberen und unteren Heißpresswalze sind 150mm. Die Temperaturen der oberen und unteren Heißpresswalzen sind im Bereich 150 bis 550 °C. Die Drücke, die auf die Filmstapel durch die oberen und unteren Heißpressrollen ausgeübt werden, sind im Bereich von 2 bis 400 MPa. Die Geschwindigkeit der Schichtstapel, die durch die oberen und unteren Heißpressrollen hindurch gehen, ist im Bereich von 0.5 bis 60m/min. Die beschichteten PTFE-Filme sind nach der Behandlung des thermischen Verbindens hergestellt. Der hergestellte beschichtete PTFE-Film tritt dann in das Elektrodenbeschichtungssystem (14) ein und Aluminiumelektroden mit einer Dicke von 100nm werden an beiden Seiten des beschichteten PTFE-Films beschichtet. Danach wird eine Gleichstromspannung im Bereich von 100- bis 20000V an die oberen und unteren Elektroden an den Oberflächen des beschichteten PTFE-Films angelegt. Die Temperatur des Kontaktladungssystems wird auf -40 bis 380°C eingestellt. Der piezoelektrische PTFE-Film ist nach der Kontaktladung hergestellt.

## Revendications

1. Procédé de production en continu de films fonctionnels de polytétrafluoroéthylène (PTFE), pour effectuer une conversion d'énergie électromécanique, qui contient deux étapes consistant en un liage thermique des piles de couches avec une structure microporeuse et une polarisation électrique de films stratifiés ainsi liés thermiquement. Les caractéristiques dudit procédé sont les suivantes : l'étape de liage thermique des piles de couches avec une structure microporeuse est telle qu'il doit y avoir au moins deux couches de PTFE compactes (6, 8) et une couche de PTFE poreuse (7) prise en sandwich entre deux films de PTFE compacts adjacents. Ensuite, les piles de films de PTFE compacts et poreux sont alimentées dans la paire de cylindres supérieur et inférieur (9, 10) de presse à chaud et y sont liées thermiquement pour former le film stratifié ; le film stratifié étant enfin polarisé électriquement obtenant ainsi un film de piézoélectret en PTFE.

2. Procédé selon la revendication 1, les caractéristiques du procédé de production en continu de film fonctionnel pour la conversion d'énergie électromécanique à base de PTFE sont les suivantes. L'étape de chargement selon la revendication 1 consiste à charger le film stratifié par effet corona en plaçant le film stratifié dans la zone située entre le cylindre électrode et l'électrode à effet corona. Le film de PTFE stratifié chargé par effet corona est ainsi obtenu et récupéré par des cylindres d'enroulement.

3. Procédé selon la revendication 1, les caractéristiques du procédé de production en continu de film fonctionnel de PTFE pour la conversion d'énergie électromécanique sont les suivantes. L'étape de chargement selon la revendication 1 consiste en ce que les électrodes sont revêtues sur les deux côtés du film stratifié dans la zone de revêtement d'électrode. Ensuite, le film stratifié avec les électrodes est alimenté dans la zone de chargement par contact afin d'être polarisé au moyen d'un chargement par contact. Le film de PTFE stratifié chargé par effet corona est ainsi obtenu et récupéré par des cylindres d'enroulement.

4. Procédé selon la revendication 2, les caractéristiques du procédé de production en continu de film fonctionnel de PTFE pour la conversion d'énergie électromécanique sont les suivantes. Le film de PTFE stratifié, transporté depuis les cylindres supérieur et inférieur (9, 10) de presse à chaud, passe à travers la zone de charge par effet corona où il est près de la surface du cylindre électrode. Ensuite, il est récupéré par le cylindre d'enroulement afin d'accomplir la production de film de piézoélectret en PTFE.

5. Procédé selon la revendication 4, les caractéristiques du procédé de production en continu de film fonctionnel de PTFE pour la conversion d'énergie électromécanique sont les suivantes. Deux couches de PTFE compactes d'une épaisseur d'approximativement 2 à 40 µm et une couche de PTFE poreuse d'une épaisseur d'environ 2 à 400 µm sont utilisées. La couche de PTFE poreuse est prise en sandwich entre les deux couches de PTFE compactes, formant des piles de couches. Les piles de couches sont ensuite liées thermiquement et forment un film stratifié au moyen d'une paire de cylindres supérieur et inférieur (9, 10) de presse à chaud. Les surfaces des cylindres supérieur et inférieur de presse à chaud sont pourvues de motifs en forme de croix. Le diamètre des cylindres supérieur et inférieur de presse à chaud est de 150 mm. Les températures des cylindres supérieur et inférieur de presse à chaud sont situées dans la plage de 100 à 450 °C. Les pressions, appliquées aux piles de films par les cylindres supérieur et inférieur de presse à chaud, sont situées dans la plage de 0,1 à 200 MPa. La vitesse des piles de films passant entre les cylindres supérieur et inférieur de presse à chaud est située dans la plage de 0,1 à 20 m/min. Les films de PTFE stratifiés sont fabriqués après le traitement de liage thermique. Les films de PTFE stratifiés sont ensuite polarisés électriquement dans la zone de chargement par effet corona. La tension du chargement par effet corona est située dans la plage de 1 à 200 kV. La distance entre l'électrode à effet corona (11) et le cylindre électrode (12) est située dans la plage de 0,1 à 50 cm. La température dans la zone à effet corona est située dans la plage de -40 à 380 °C. Les films de piézoélectret en PTFE sont fabriqués après le traitement de chargement par effet corona.

6. Procédé selon la revendication 3, les caractéristiques du procédé de production en continu de film fonctionnel de PTFE pour la conversion d'énergie électromécanique sont les suivantes. Un système de revêtement d'électrode (14) et un système de chargement par contact (15, 16) sont placés entre les cylindres supérieur et inférieur (9, 10) de presse à chaud et le cylindre d'enroulement (13). Le film de PTFE stratifié transporté depuis les cylindres supérieur et inférieur (9, 10) de presse à chaud entre d'abord dans le système de revêtement d'électrode (14), formant de bonnes électrodes des deux côtés des films, puis va dans le système de chargement par contact (15, 16) en étant entraîné par le cylindre d'enroulement (13). Une tension CC élevée est appliquée aux électrodes supérieure et inférieure du film de PTFE stratifié afin d'accomplir la polarisation. Enfin, le film de PTFE stratifié polarisé est récupéré par des cylindres d'enroulement et la fabrication du film de piézoélectret en PTFE est finie.

7. Procédé selon la revendication 6, les caractéristiques du procédé de production en continu de film fonctionnel de PTFE pour la conversion d'énergie électromécanique sont les suivantes. Deux couches de PTFE compactes d'une épaisseur d'approximativement 20 à 200 µm et une couche de PTFE poreuse d'une épaisseur d'approximativement 20 à 1000 µm sont utilisées. La couche de PTFE poreuse est prise en sandwich entre les deux couches de PTFE compactes, formant des piles de couches. Les piles de couches sont ensuite liées thermiquement et forment un film stratifié au moyen d'une paire de cylindres supérieur et inférieur (9, 10) de presse à chaud. Les surfaces des cylindres supérieur et inférieur de presse à chaud sont pourvues de motifs en forme de croix. Le diamètre des cylindres supérieur et inférieur de presse à chaud est de 150 mm. Les températures des cylindres supérieur et inférieur de presse à chaud sont situées dans la plage de 150 à 550 °C. Les pressions, appliquées aux piles de films par les cylindres supérieur et inférieur de presse à chaud, sont situées dans la plage de 2 à 400 MPa. La vitesse des piles de films passant entre les cylindres supérieur et inférieur de presse à chaud est située dans la plage de 0,5 à 60 m/min. Les films de PTFE stratifiés sont fabriqués après le traitement de liage thermique. Le film de PTFE stratifié fabriqué entre ensuite dans le système de revêtement d'électrode (14) et des électrodes d'aluminium, d'une épaisseur de 100 nm, sont revêtues sur les deux côtés du film de PTFE stratifié. Ensuite, une tension CC située dans la plage d'approximativement 100 à 20 000 V est appliquée aux électrodes supérieure et inférieure sur les surfaces du film de PTFE stratifié. La température du système de chargement par contact est réglée entre approximativement -40 et 380 °C. Le film de piézoélectret en PTFE est fabriqué après le chargement par contact.
